Europäisches Patentamt

European Patent Office

Office européen des brevets

(11) Veröffentlichungsnummer: **0 557 748 A2**

# EUROPÄISCHE PATENTANMELDUNG

(21) Anmeldenummer: **93101655.4**

(22) Anmeldetag: **03.02.93**

(51) Int. Cl.5: **H03K 23/50**, H03K 19/096

(30) Priorität: **27.02.92 DE 4206082**

(43) Veröffentlichungstag der Anmeldung:
**01.09.93 Patentblatt 93/35**

(84) Benannte Vertragsstaaten:
**DE FR GB IT NL**

(71) Anmelder: **SIEMENS AKTIENGESELLSCHAFT**
**Wittelsbacherplatz 2**
**D-80312 München(DE)**

(72) Erfinder: **Hölzle, Josef, Dipl.-Ing. (FH)**
**Südweg 8**
**W-8939 Bad Wörishofen(DE)**

(54) Synchrones, digitales Schaltwerk.

㉗ Die Erfindung betrifft ein synchrones, digitales Schaltwerk mit zustandsgesteuerten Speicherelementen, die jeweils einen Takteingang, mindestens zwei zueinander komplementäre Ausgänge und mindestens zwei Eingänge aufweisen, die zu einer logischen ODER-Verknüpfung verbunden sind.

Mindestens zwei zustandsgesteuerte Speicherelemente (10, 11) sind hintereinander geschaltet. Ein erstes Speicherelement (10) führt die ODER-Verknüpfungen und ein zweites Speicherelement (11) die UND-Verknüpfungen einer kombinatorischen logischen Funktion aus. Es fallen jeweils die Setzzeit eines Speicherelementes und die Verzögerungszeit zur Bildung der ODER- bzw. UND- Verknüpfungen zusammen. Somit ist eine hohe Verarbeitungsgeschwindigkeit im Schaltwerk möglich.

FIG1

EP 0 557 748 A2

Schaltwerke sind digitale, synchron getaktete Systeme, in denen der Systemzustand in Speicherelementen gespeichert wird. Aus Eingangssignalen und den gespeicherten Signalen werden mittels kombinatorischer Logik Ausgangssignale berechnet. Solche Schaltwerke sind beispielsweise aus der Literaturstelle Tietze, Schenk: "Halbleiterschaltungstechnik", 7. Auflage, Seite 259 bis 261 bekannt. Als Speicherelemente werden dort flankengesteuerte Speicherelemente verwendet. Bei flankengesteuerten Speicherelementen müssen üblicherweise die Daten mindestens eine bestimmte Zeitspanne vor der Taktflanke an den Dateneingängen des Speicherelementes anliegen. Diese Zeitspanne wird als Setzzeit bezeichnet. Mit dem Taktimpuls werden die Daten in Speicherelementen gespeichert. Es dauert dann eine gewisse Zeitspanne, bis die Daten am Ausgang erscheinen. Diese Zeit wird als Verzögerungszeit des Speicherelementes bezeichnet. Für die Berechnung der kombinatorischen Logik zwischen zwei aufeinander folgenden Taktflanken steht demnach eine Taktperiode abzüglich der Verzögerungszeit und der Setzzeit der Speicherelemente zur Verfügung. Die maximale Verarbeitungsgeschwindigkeit des Schaltwerks ist dann erreicht, wenn die Summe aus der Verzögerungszeit und der Setzzeit des Speicherelementes und der Verzögerungszeit der kombinatorischen Logik gleich der Länge einer Taktperiode ist.

Die nachfolgend beschriebene Erfindung betrifft gemäß einer ersten Alternative ein synchrones, digitales Schaltwerk mit den Merkmalen:

(a) mindestens ein erstes und ein zweites taktzustandsgesteuertes Speicherelement mit je einem Takteingang, mindestens zwei zueinander komplementären Ausgängen und mindestens zwei Eingängen sind hintereinandergeschaltet, indem einer der Ausgänge des ersten Speicherelementes mit einem der Eingänge des zweiten Speicherelementes verbunden ist,

(b) einer der Ausgänge des letzten der hintereinandergeschalteten Speicherelemente ist auf einen ersten Teil der Eingänge des ersten Speicherelementes rückgekoppelt,

(c) ein zweiter Teil der Eingänge des ersten Speicherelementes ist mit Eingängen des Schaltwerks verbunden und einer der Ausgänge des zweiten Speicherelementes dient als Ausgang des Schaltwerks,

(d) die Takteingänge der Speicherelemente werden von zueinander phasenverschobenen Taktsignalen gesteuert und

und gemäß einer zweiten Alternative ein synchrones, digitales Schaltwerk mit den Merkmalen:

(a) mindestens eine erste und eine zweite Gruppe mit mindestens je einem taktzustandsgesteuerten Speicherelement mit einem Takteingang, mindestens zwei zueinander komplementären Ausgängen und mindestens zwei Eingängen sind hintereinandergeschaltet, indem einer der Ausgänge des Speicherelementes der ersten Gruppe mit einem der Eingänge des Speicherelementes der zweiten Gruppe verbunden ist,

(b) einer der Ausgänge des Speicherelementes der letzten der hintereinandergeschalteten Gruppen ist auf einen ersten Teil der Eingänge des Speicherelementes der ersten Gruppe rückgekoppelt,

(c) ein zweiter Teil der Eingänge des Speicherelementes der ersten Gruppe ist mit Eingängen des Schaltwerks verbunden und einer der Ausgänge des Speicherelementes der zweiten Gruppe dient als Ausgang des Schaltwerks,

(d) die Takteingänge der Speicherelemente einer jeden Gruppe werden von zueinander phasenverschobenen Taktsignalen gesteuert.

Auf Seite 234 der 6. Auflage des vorgenannten Buches ist ein Master-Slave-Flip Flop aus zwei hintereinander geschalteten RS-Flip Flops gezeigt. Die Ausgänge des zweiten Flip Flops sind auf die Eingänge des ersten Flip Flops mittels einer UND-Verknüpfung rückgekoppelt. Dadurch wird nur ein spezielles logisches Schaltwerk, nämlich ein JK-Flip Flop erzeugt.

Der Erfindung liegt die Aufgabe zugrunde, eine Realisierung für ein beliebiges, logisches Schaltwerk anzugeben, die eine hohe Verarbeitungsgeschwindigkeit erlaubt.

Diese Aufgabe wird dadurch gelöst, daß

(e) jedes der Speicherelemente ein taktzustandsgesteuertes D-Flip Flop und ein ODER-Schaltglied enthält,

(f) der Ausgang des ODER-Schaltgliedes mit dem Eingang des D-Flip Flops verbunden ist, die Eingänge des Speicherelementes die Eingänge des ODER-Schaltgliedes sind und die komplementären Ausgänge des Speicherelementes die komplementären Ausgänge des D-Flip Flops sind,

(g) bei der ersten Alternative die Taktsignale von je zwei hintereinandergeschalteten Speicherelementen um eine Phase von einer durch die Anzahl von Speicherelementen geteilten Taktperiode zueinander phasenverschoben sind und bei der zweiten Alternative die Taktsignale von je zwei hintereinandergeschalteten Gruppen von Speicherelementen um eine Phase von einer durch die Anzahl von Gruppen geteilten Taktbereich zueinander phasenverschoben sind.

Die Erfindung wird im folgenden anhand der in der Zeichnung dargestellten Ausführungsbeispiele erläutert. Es zeigen

FIG 1 die erfindungsgemäße Realisierung eines Schaltwerks,

FIG 2 ein Taktsignaldiagramm der Schaltung der FIG 1,

FIG 3 die Realisierung eines Schaltwerks mit vier Speicherelementen,

FIG 4 die Realisierung eines Schaltwerks mit zwei Speicherelementen und ihnen vorgeschalteten ODER-Schaltgliedern,

FIG 5 die Ausführung eines zustandsgesteuerten Speicherelementes in Stromschaltertechnik und

FIG 6 ein Schaltwerk gemäß dem Stand der Technik.

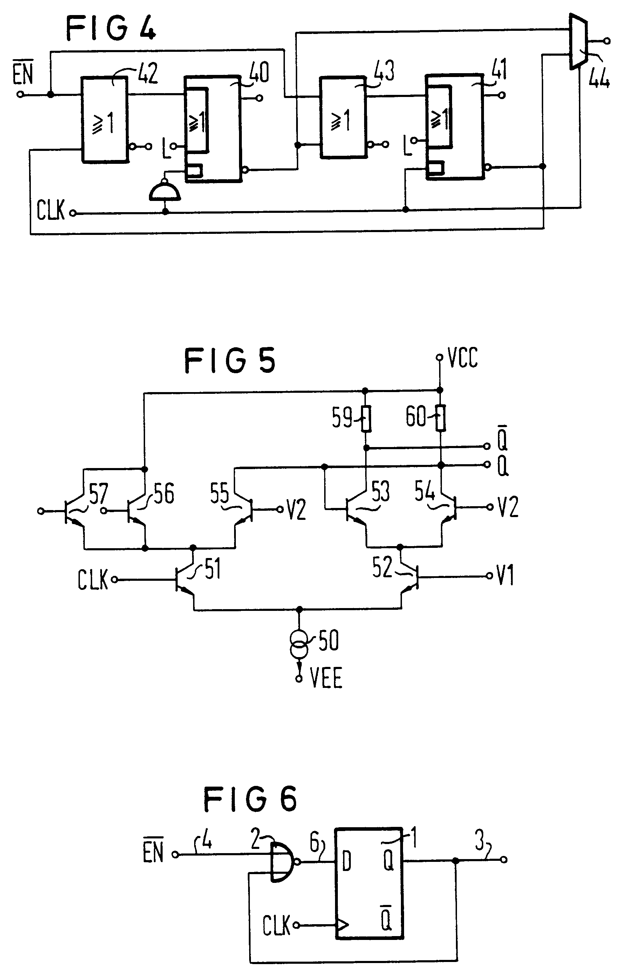

In der FIG 6 ist ein Schaltwerk gemäß dem Stand der Technik gezeigt. Es handelt sich hierbei um einen mit einem Freigabeeingang versehenen Teiler durch 2, der ein taktflankengesteuerten Speicherelement enthält. Das taktflankengesteuerte Speicherelement ist ein D-Flip Flop. Der Ausgang 3 des D-Flip Flops 1 ist auf seinen Eingang rückgeführt. Ein L-aktives Freigabesignal $\overline{EN}$ ist mit der Rückführung über ein NICHT-ODER-Schaltglied 2 verbunden. Wenn der Freigabeeingang auf L-Potential liegt, stellt sich am Ausgang des NICHT-ODER-Schaltgliedes 2 der negierte Wert des Ausgangssignales des D-Flip Flops ein. Mit der darauffolgenden negativen Taktflanke wird dieser logische Wert im D-Flip Flop 1 gespeichert. Am Ausgang 3 erscheint demnach eine alternierende Folge von L und H mit einer bezüglich der Frequenz des Taktsignales CLK halbierten Frequenz. Wenn das Freigabesignal $\overline{EN}$ H ist, ist der Ausgang des NICHT-ODER-Schaltgliedes 2 stets L, so daß der Ausgang 3 auf L bleibt.

Bei einem taktflankengesteuerten Speicherelement wie beispielsweise dem D-Flip Flop 1 müssen in der Regel gültige Datensignale an seinem Eingang 6 um eine gewisse Zeitspanne, die sogenannte Setzzeit, vor der Taktflanke anliegen. Die Datensignale dürfen sich während der Setzzeit nicht mehr verändern. Nach der Taktflanke dauert es die sogenannte Verzögerungszeit des Speicherelementes, bis das am Dateneingang anliegende Signal am Ausgang 3 gültig erscheint. Die Zeitspanne von zwei aufeinander folgenden Taktflanken, also einer Taktperiode, abzüglich der Setz- und der Verzögerungszeit steht für die Verzögerungszeit des NICHT- ODER-Schaltgliedes 2 maximal zur Verfügung. Die höchste Verarbeitungsgeschwindigkeit des Schaltwerkes der FIG 6 ist demnach durch die Summe aus Setz- und Verzögerungszeit des D-Flip Flops 1 und der Verzögerungszeit des Schaltgliedes 2 begrenzt.

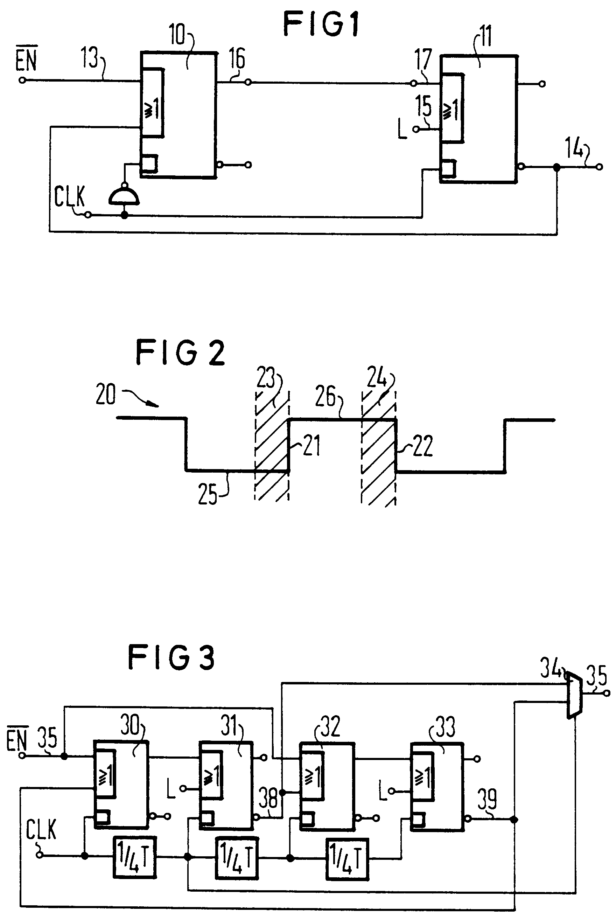

In FIG 1 ist eine erfindungsgemäße Realisierung eines Schaltwerks gezeigt, die die gleiche Funktion wie das in FIG 6 dargestellte Schaltwerk ausführt. Zwei zustandsgesteuerte Speicherelemente 10, 11 sind hintereinander geschaltet, indem der Ausgang 16 des Speicherelementes 10 mit einem der Eingänge 17 des Speicherelementes 11 verbunden ist. Der andere Eingang 15 des Speicherelementes 11 ist mit einem L-Potential verbunden. Der negierte Ausgang 14 des Speicherelementes 11 dient als Ausgang des Schaltwerkes und ist auf einen der Eingänge des Speicherelementes 10 rückgeführt. Der andere Eingang 13 des Speicherelementes 10 wird von dem Freigabesignal $\overline{EN}$ gesteuert. Am Takteingang des Speicherelementes 11 liegt das Taktsignal CLK an, während das Speicherelement 10 von dem negierten, also um eine halbe Taktperiode verschobenen Taktsignal gesteuert wird.

Als taktzustandsgesteuerte Speicherelemente 10, 11 sind jeweils ein Speicherelement vorgesehen, das einen Ausgang und einen dazu komplementären Ausgang aufweist. Es hat weiterhin zwei Eingänge, die zu einer logischen ODER-Verknüpfung verbunden sind. Das Ergebnis dieser ODER-Verknüpfung wird im Speicherelement gespeichert. Während der H-Phase des Taktsignals ist das Speicherelement transparent, das heißt, daß das Ergebnis der ODER- Verknüpfung an den Ausgängen des Speicherelementes vorliegt und Änderungen des Ergebnisses unmittelbar auch an den Ausgängen wirksam werden. Während der L-Phase des Taktsignals ist dasjenige Ergebnis gespeichert, das unmittelbar vor der Taktflanke gespeichert war. Die Berechnung der ODER-Verknüpfung dauert eine bestimmte Zeitspanne. Wenn sich die Daten an den Eingängen des Speicherelements während dieser Zeitspanne nicht ändern, liegt unmittelbar nach der Taktflanke an den Ausgängen des Speicherelementes das gültige Ergebnis vor. Demnach ist bei einem solchen taktzustandsgesteuerten, transparenten Speicherelement keine Verzögerungszeit nach dem Speichervorgang vorhanden.

Zur Erläuterung der Funktionsweise des Schaltwerkes in FIG 1 ist in FIG 2 ein Taktsignaldiagramm gezeigt. Während der L-Phase 25 des Taktsignals 20 ist das Speicherelement 10 transparent. Zum Zeitpunkt der Taktflanke 21 wird das Ergebnis der ODER-Verknüpfung aus den Signalen $\overline{EN}$ und dem rückgeführten Signal des Ausgangs 14 gespeichert. Die Zeitspanne 23 ist die Setzzeit des Speicherelements 10. Während der H-Phase 26 des Taktsignals 20 ist das Speicherelement 11 transparent und speichert an der Taktflanke 22 die ODER-Verknüpfung der Signale an seinen Eingängen 17 und 15. Zu jeder negativen Taktflanke liegt demnach ein gültiges Signal am Ausgang 14 an. Die Länge einer Taktperiode muß mindestens zwei Setzzeiten 23, 24 eines taktzustandsgesteuerten Speicherelementes sein. Es entfallen im Hinblick auf das Schaltwerk der FIG 6 die Verzögerungszeit für das Schaltglied 2 und die Verzögerungszeit des taktflankengesteuerten D- Flip Flops 1. Geht man von annähernd gleichgroßen Setzzeiten für taktzustandsgesteuerte und taktflankengesteuerte Speicherelemente aus, kann die Geschwindigkeit bei einem erfindungsgemäß realisierten Schaltwerk demnach wesentlich höher gewählt werden als bei einer Realisierung nach dem Stand der Technik.

Bei der zu realisierenden logischen Funktion wird die Aufgabe der Datenspeicherung durch die beiden hintereinander geschalteten taktzustandsgesteuerten Speicherelemente 10, 11 ausgeführt. Während der L-Phase 25 des Taktsignals werden sämtliche ODER- Verknüpfungen und während der H-Phase 26 sämtliche UND-Verknüpfungen der zu realisierenden kombinatorischen Logik berechnet. Die vorliegende kombinatorische Logik enthält eine NICHT-ODER-Verknüpfung. Ohne ihr Ergebnis zu beeinflussen, ist sie durch eine nachgeschaltete UND-Verknüpfung mit einem logischen H-Pegel erweitert. Die NICHT-ODER-Verknüpfung wird im Speicherelement 10 berechnet, die UND-Verknüpfung mit dem logischen H-Pegel im Speicherelement 11. Da die UND-Verknüpfung mittels eines ODER-Schaltelementes im Speicherelement 11 ausgeführt wird, werden die Eingangssignale und die Ausgangssignale negiert. Demzufolge ist der Eingang 17 des Speicherelementes 11 mit dem positiven Ausgang des Speicherelementes 10, der andere Eingang 15 des Speicherelementes 11 mit einem L-Pegel und der Ausgang des Schaltwerks mit dem negativen Ausgang des Speicherelementes 11 verbunden.

Eine weitere Realisierungsmöglichkeit des vorliegenden Schaltwerkes ist in FIG 3 gezeigt. Dort sind vier zustandsgesteuerte Speicherelemente 30, ..., 33 hintereinander geschaltet. Die Anordnung der Speicherelemente 30, 31 entspricht der in der FIG 1 gezeigten Schaltung. Ihnen ist eine entsprechende Anordnung mit den Speicherelementen 32, 33 nachgeschaltet. Die Eingangssignale des Speicherelementes 32 sind das Eingangssignal $\overline{EN}$ und das Ausgangssignal des Speicherelements 31. Die Ausgangssignale des Schaltwerks liegen an den Ausgängen 38, 39 der Speicherelemente 31 bzw. 33 an. Die Taktsignale von hintereinander geschalteten Speicherelementen sind jeweils um ein Viertel einer Taktperiode verschoben.

Wenn das Taktsignal CLK an einer ersten Taktflanke von einem H- Pegel auf einen L-Pegel übergeht, wird im Speicherelement 30 das Ergebnis der ODER-Verknüpfung aus einem ersten Wert des Eingangssignales $\overline{EN}$ und dem Signal am Ausgang 39 des letzten der hintereinander geschalteten Speicherelemente berechnet. Das Ergebnis der UND-Verknüpfung am Ausgang 38 des Speicherelementes 31 liegt eine Vierteltaktperiode später vor. Für die Berechnung der logischen Funktion für den ersten Wert des Eingangssignales $\overline{EN}$ wird demnach eine halbe Taktperiode benötigt. Ein auf den ersten Wert zeitlich folgender zweiter Wert des Eingangssignal $\overline{EN}$ wird im Speicherelement 32 mit dem Ergebnis der ersten Berechnung am Ausgang 38 verknüpft. Eine halbe Taktperiode später liegt das Ergebnis der logischen Funktion für den zweiten Wert am Ausgang 39 des Speicherelementes 33 vor. Für die Berechnung von zwei zeitlich aufeinander folgenden Werten des Eingangssignales EN ist demnach eine Periode des Taktsignales notwendig. Das Schaltwerk der FIG 2 hat den Vorteil, daß die Frequenz des Taktsignales CLK gleich der Frequenz des Eingangssignals EN ist. Die Ausgangssignale an den Ausgängen 38, 39 der Speicherelemente 31 bzw. 33 werden über einen Multiplexer 34 auf einen weiteren Ausgang 35 des Schaltwerkes geführt. Der Multiplexer 34 wird von dem Taktsignal des Speicherelementes 31 so gesteuert, daß jeweils eines der Ausgangssignale an den Ausgängen 38, 39 während derjenigen Hälfte der Taktperiode am Ausgang 35 erscheint, die auf den zugehörigen ersten bzw. zweiten Wert des Eingangssignales $\overline{EN}$ folgt.

In der FIG 4 ist die erfindungsgemäße Realisierung des aus der FIG 6 bekannten Schaltwerkes mit zwei zustandsgesteuerten Speicherelementen und den Speicherelementen vorgeschalteten ODER- Schaltgliedern gezeigt. Den Speicherelementen 40, 41 ist jeweils ein ODER-Schaltglied 42 bzw. 43 vorgeschaltet, indem der positive Ausgang der ODER-Schaltglieder mit einem der Eingänge der Speicherelemente verbunden ist. Die ODER-Schaltglieder weisen mindestens zwei Eingänge und einen zum positiven Ausgang komplementären Ausgang auf. Einer der Eingänge der ODER-Schaltglieder 42, 43 wird vom Freigabesignal $\overline{EN}$ gesteuert, der andere Eingang ist mit dem negierten Ausgang des Speicherelementes 41 bzw. 40 verbunden. Die Speicherelemente 40, 41 werden von um die Hälfte einer Taktperiode phasenverschobenen Taktsignalen gesteuert. Den negierten Ausgängen der Schaltelemente 40, 41 ist ein Multiplexer nachgeschaltet, der vom Taktsignal CLK gesteuert wird. Die Schaltung der FIG 4 entspricht der Schaltung der FIG 3 mit der Ausnahme, daß anstelle der dort vorhandenen Speicherelemente 30, 32 die ODER-Schaltglieder 42, 43 vorhanden sind. Dies bedeutet, daß die speichernde Funktion der Speicherelemente 30, 32 wegfällt und die Funktion der ODER-Verknüpfungen der Schaltglieder 30, 32 durch die ODER-Schaltglieder 42, 43 ausgeführt wird. Die Schaltung der FIG 4 hat gegenüber der Schaltung der FIG 3 den Vorteil, daß Bauelemente gespart werden. Letztere hingegen weist den Vorteil auf, daß stets gleichartige Bauelemente verwendet werden und deshalb eine regelmäßige Struktur möglich ist.

Die bisher beschriebenen Ausführungsbeispiele der FIG 1, 3, 4 sind verschiedene Realisierungsmöglichkeiten derselben logischen Schaltung. Wenn eine andere logische Funktion realisiert wird, bei der mehr als ein logischer Wert gespeichert wird, wird bei einer erfindungsgemäßen Realisierung anstelle von nur einem der Speicherelemente 10, 11 bzw. 30, .., 33 bzw. 40, 41 jeweils eine Gruppe mit mehr als einem Speicherelement vorgesehen. Alle Speicherelemente einer Gruppe werden vom gleichen Taktsignal gesteuert. Im Fall der Realisierung nach FIG 4 sind auch Gruppen von ODER-Schaltgliedern vorgesehen, die den ODER-Schaltgliedern 42, 43 entsprechen. Jede dieser Gruppen wird in der entsprechenden Weise wie die in den Ausführungsbeispielen gezeigten einzelnen Speicherelemente und ODER-Schaltglieder verbunden. Die konkrete Verbindung aller Ein- und Ausgänge jedes der Speicherelemente und ODER-Schaltglieder hängt von der jeweils zu realisierenden logischen Funktion ab.

Eine Ausführungsform eines transparenten, taktzustandsgesteuerten Speicherelementes ist in der FIG 5 gezeigt. Die vorliegende Schaltung ist in bipolarer Stromschaltertechnik realisiert. Ein Stromschalter enthält zwei emittergekoppelte Bipolartransistoren 51, 52, deren Emitter über eine Stromquelle 50 mit einem Versorgungspotential VEE verbunden sind. Die Kollektoren dieser Transistoren sind jeweils mit den Emittern eines weiteren Transistorpaares 56, 55 bzw. 53, 54 verbunden. Die Kollektoren der Transistoren 53, 54 sind jeweils über einen Widerstand 59 bzw. 60 mit einem weiteren Versorgungspotential VCC verbunden. Die Kollektoren der Transistoren 55, 54 sind gekoppelt und bilden den Ausgang Q. Der Kollektor des Transistors 53 dient als dazu komplementärer Ausgang $\overline{Q}$. Die Basis des Transistors 52 ist mit einem ersten Referenzpotential V1 verbunden, die Basisanschlüsse der Transistoren 55, 54 sind mit einem weiteren Referenzpotential V2 verbunden. An der Basis des Transistors 51 liegt das Taktsignal CLK. Parallel zur Kollektor-Emitter-Strecke des Transistors 56, dessen Basis von einem Eingangssignal gesteuert wird, liegt die Kollektor-Emitter-Strecke eines weiteren Bipolartransistors 57, 58, dessen Basisanschluß von einem weiteren Eingangssignal gesteuert wird. Das Ausgangssignal Q ist auf die Basis des Transistors 53 rückgekoppelt. Die Eingänge der Transistoren 56, 57 sind zu einer ODER-Verknüpfung verbunden. Die ODER-Verknüpfung entsteht aufgrund der parallel geschalteten Kollektor Emitter-Strecken dieser Transistoren, ohne jedoch eine zusätzliche Signallaufzeit zu bewirken. Prinzipiell ist es möglich, den Transistoren 56, 57 weitere Eingangstransistoren zur Bildung eines Speicherelementes mit mehr als zwei Eingangssignalen parallel zu schalten.

Die Schaltung arbeitet folgendermaßen: Das Taktsignal CLK sei H. Der Strom der Stromquelle 50 fließt demnach durch den Transistor 51, während der Transistor 52 gesperrt ist. Wenn mindestens einer der Transistoren 56, 57 von einem H-Pegel gesteuert wird, fließt ein Strom durch diesen Transistor und der Transistor 55 ist gesperrt. Der Ausgang Q liegt dann auf H-Potential, da durch den Widerstand 60 kein Strom fließt. Am Ausgang Q stellt sich somit die ODER-Verknüpfung der Eingangssignale ein. Ändert sich das Ergebnis der ODER-Verknüpfung, indem beispielsweise alle Eingangstransistoren gesperrt sind, fließt der Strom durch den Transistor 55 und bewirkt am Ausgang Q einen L-Pegel. Dies geschieht unmittelbar auf die Änderung der Eingangssignale hin, das heißt, das Flip Flop ist transparent. Schaltet das Taktsignal auf einen L-Pegel, fließt der Strom durch den Transistor 52. Durch die Rückkopplung des Ausgangs Q auf die Basis des Transistors 53 wird der gerade vorliegende Pegel am Ausgang Q gespeichert. Der Ausgang $\overline{Q}$ verhält sich invers zum Ausgang Q. Wenn sich jetzt die Eingangspegel an den Transistoren 56, 57 ändern, wirkt sich dies nicht auf die Ausgänge Q, $\overline{Q}$ aus, da der Transistor 51 stromlos ist.

Wenn das Taktsignal CLK H ist, der Strom also durch den Transistor 51 fließt, tritt eine erste Verzögerungszeit zwischen Pegeländerungen an den Eingängen der Transistoren 56, 57 und der Reaktion darauf an den Ausgängen Q, $\overline{Q}$ aufgrund von parasitären Kollektor-Substrat-Kapazitäten auf. Ebenso ist eine zweite Verzögerungszeit für das Umschalten des Stromes vom Transistor 51 auf den Transistor 52 bei einer negativen Taktflanke vorhanden. Wenn der gespeicherte Pegel an den Ausgängen Q, $\overline{Q}$ zum Zeitpunkt der negativen Taktflanke gültig sein soll, dürfen die Eingangssignale innerhalb der ersten und der zweiten Verzögerungszeit vor dem Einsetzen der Taktflanke nicht verändert werden. Die Setzzeit des Speicherelementes, d.h. diejenige Zeitdauer vor der Taktflanke, während der die Daten nicht mehr verändert werden dürfen, wird demnach durch die längere dieser beiden Verzögerungszeiten festgelegt. Das Speicherelement hat den Vorteil, daß die Verzögerungszeit für die Berechnung der kombinatorischen Logik und die Setzzeit des Speicherelements zusammenfallen.

**Patentansprüche**

1. Synchrones, digitales Schaltwerk mit den Merkmalen:
   (a) mindestens ein erstes und ein zweites taktzustandsgesteuertes Speicherelement (10, 11) mit je einem Takteingang, mindestens zwei zueinander komplementären Ausgängen und mindestens zwei Eingängen sind hintereinandergeschaltet, indem einer der Ausgänge des ersten Speicherelementes (10) mit einem der Eingänge des zweiten Speicherelementes (11) verbunden ist,

(b) einer der Ausgänge des letzten der hintereinandergeschalteten Speicherelemente (11) ist auf einen ersten Teil der Eingänge des ersten Speicherelementes (10) rückgekoppelt,

(c) ein zweiter Teil der Eingänge des ersten Speicherelementes (10) ist mit Eingängen (13) des Schaltwerks verbunden und einer der Ausgänge des zweiten Speicherelementes (11) dient als Ausgang (14) des Schaltwerks,

(d) die Takteingänge der Speicherelemente werden von zueinander phasenverschobenen Taktsignalen (CLK) gesteuert,

**dadurch gekennzeichnet,** daß

(e) jedes der Speicherelemente (10, 11) ein taktzustandsgesteuertes D-Flip Flop und ein ODER-Schaltglied enthält,

(f) der Ausgang des ODER-Schaltgliedes mit dem Eingang des D-Flip Flops verbunden ist, die Eingänge des Speicherelementes die Eingänge des ODER-Schaltgliedes sind und die komplementären Ausgänge des Speicherelementes die komplementären Ausgänge des D-Flip Flops sind,

(g) die Taktsignale (CLK) von je zwei hintereinandergeschalteten Speicherelementen (10, 11) um eine Phase von einer durch die Anzahl von Speicherelementen geteilten Taktperiode zueinander phasenverschoben sind.

2. Schaltwerk nach Anspruch 1,
**dadurch gekennzeichnet,** daß

a) ein drittes und ein viertes Speicherelement (32, 33) vorhanden sind,

b) daß einer der Ausgänge des zweiten Speicherelementes (31) mit einem ersten Teil der Eingänge des dritten Speicherelementes (32), einer der Ausgänge des dritten Speicherelementes (32) mit einem der Eingänge des vierten Speicherelementes (33) verbunden ist,

c) ein zweiter Teil der Eingänge des dritten Speicherelementes (33) mit den Eingängen (35) des Schaltwerkes verbunden ist und einer der Ausgänge des vierten Speicherelementes (33) als weiterer Ausgang (39) des Schaltwerkes dient.

3. Schaltwerk nach Anspruch 1,
**dadurch gekennzeichnet,** daß dem ersten und dem zweiten Speicherelement (40, 41) jeweils ein ODER-Schaltglied (42, 43) mit jeweils mindestens zwei Eingängen und mindestens zwei zueinander komplementären Ausgängen vorgeschaltet ist, indem

a) ein erster Teil der Eingänge der ODER-Schaltglieder (42, 43) mit den Eingängen des Schaltwerks verbunden ist,

b) ein zweiter Teil der Eingänge des dem ersten Speicherelement vorgeschalteten ODER-Schaltgliedes (42) mit einem der Ausgänge des zweiten Speicherelementes (41) verbunden ist und ein zweiter Teil der Eingänge des dem zweiten Speicherelement vorgeschalteten ODER-Schaltgliedes (43) mit einem der Ausgänge des ersten Speicherelementes (40) verbunden ist,

c) einer der Ausgänge des dem ersten Speicherelement vorgeschalteten ODER-Schaltgliedes (42) mit einem der Eingänge des ersten Speicherelementes (40) und einer der Ausgänge des dem zweiten Speicherelement vorgeschalteten ODER-Schaltgliedes (43) mit einem der Eingänge des zweiten Speicherelementes (41) verbunden ist,

d) einer der Ausgänge des zweiten Speicherelementes (41) als weiterer Ausgang des Schaltwerkes dient.

4. Schaltwerk nach Anspruch 2 oder 3, **dadurch gekennzeichnet,** daß der Ausgang und der weitere Ausgang des Schaltwerks mit Eingängen eines Multiplexers (34, 44) verbunden sind, der von einem der an den Takteingängen der Speicherelemente anliegenden Taktsignale gesteuert wird.

5. Synchrones, digitales Schaltwerk mit den Merkmalen:

(a) mindestens eine erste und eine zweite Gruppe mit mindestens je einem taktzustandsgesteuerten Speicherelement (10, 11) mit einem Takteingang, mindestens zwei zueinander komplementären Ausgängen und mindestens zwei Eingängen sind hintereinandergeschaltet, indem einer der Ausgänge des Speicherelementes (10) der ersten Gruppe mit einem der Eingänge des Speicherelementes (11) der zweiten Gruppe verbunden ist,

(b) einer der Ausgänge des Speicherelementes der letzten der hintereinandergeschalteten Gruppen (11) ist auf einen ersten Teil der Eingänge des Speicherelementes (10) der ersten Gruppe rückgekoppelt,

(c) ein zweiter Teil der Eingänge des Speicherelementes (10) der ersten Gruppe ist mit Eingängen (13) des Schaltwerks verbunden und einer der Ausgänge des Speicherelementes (11) der zweiten Gruppe dient als Ausgang (14) des Schaltwerks,

(d) die Takteingänge der Speicherelemente einer jeden Gruppe werden von zueinander phasenverschobenen Taktsignalen (CLK) gesteuert,

**dadurch gekennzeichnet,** daß

(e) jedes der Speicherelemente (10, 11) ein taktzustandsgesteuertes D-Flip Flop und ein ODER-Schaltglied enthält,

(f) der Ausgang des ODER-Schaltgliedes mit dem Eingang des D-Flip Flops verbunden ist, die Eingänge des Speicherelementes die Eingänge des ODER-Schaltgliedes sind und die komplementären Ausgänge des Speicherelementes die komplementären Ausgänge des D-Flip Flops sind,

(g) die Taktsignale (CLK) von je zwei hintereinandergeschalteten Gruppen von Speicherelementen (10, 11) um eine Phase von einer durch die Anzahl von Gruppen geteilten Taktperiode zueinander phasenverschoben sind.

6. Schaltwerk nach Anspruch 5, **dadurch gekennzeichnet,** daß

a) eine dritte und eine vierte Gruppe von Speicherelementen (32, 33) vorhanden sind,

b) daß einer der Ausgänge der Speicherelemente der zweiten Gruppe (31) mit einem ersten Teil der Eingänge der Speicherelemente der dritten Gruppe (32), einer der Ausgänge der Speicherelemente der dritten Gruppe (32) mit einem der Eingänge der Speicherelemente der vierten Gruppe (33) verbunden ist,

c) ein zweiter Teil der Eingänge der Speicherelemente der dritten Gruppe (33) mit den Eingängen (35) des Schaltwerkes verbunden ist und einer der Ausgänge der Speicherelemente der vierten Gruppe (33) als weitere Ausgänge (39) des Schaltwerkes dienen.

7. Schaltwerk nach Anspruch 5, **dadurch gekennzeichnet,** daß den Speicherelementen der ersten und zweiten Gruppe (40, 41) jeweils ein ODER-Schaltglied (42, 43) mit jeweils mindestens zwei Eingängen und mindestens zwei zueinander komplementären Ausgängen vorgeschaltet ist, indem

a) ein erster Teil der Eingänge der ODER-Schaltglieder (42, 43) mit den Eingängen des Schaltwerks verbunden ist,

b) ein zweiter Teil der Eingänge der den Speicherelementen der ersten Gruppe vorgeschalteten ODER-Schaltglieder (42) mit einem der Ausgänge der Speicherelemente der zweiten Gruppe (41) verbunden ist und ein zweiter Teil der Eingänge der den Speicherelementen der zweiten Gruppe vorgeschalteten ODER- Schaltglieder (43) mit einem der Ausgänge der Speicherelemente der ersten Gruppe (40) verbunden ist,

c) einer der Ausgänge der den Speicherelementen der ersten Gruppe vorgeschalteten ODER-Schaltglieder (42) mit einem der Eingänge der Speicherelemente der ersten Gruppe (40) und einer der Ausgänge der den Speicherelementen der zweiten Gruppe (41) vorgeschalteten ODER-Schaltglieder (43) mit einem der Eingänge der Speicherelemente der zweiten Gruppe (41) verbunden ist,

d) einer der Ausgänge der Speicherelemente der zweiten Gruppe (41) als weitere Ausgänge des Schaltwerkes dienen.

8. Schaltwerk nach Anspruch 6 oder 7, **dadurch gekennzeichnet,** daß die Ausgänge und die weiteren Ausgänge des Schaltwerkes paarweise mit Eingängen von Multiplexern (34, 44) verbunden sind, und die Multiplexer von einem der an den Takteingängen der Speicherelemente anliegenden Taktsignale gesteuert werden.

9. Schaltwerk einem der Ansprüche 1 bis 3 oder 5 bis 7, **dadurch gekennzeichnet,** daß die Speicherelemente in bipolarer Stromschaltertechnik realisiert sind und die Kollektor-Emitter-Strecken von Eingangstransistoren (56, 57) parallel geschaltet sind.

# FIG 1

# FIG 2

# FIG 3

## FIG 4

## FIG 5

## FIG 6